# DEMANDE DE BREVET EUROPEEN

(11) **EP 2 887 150 A1**
(43) Date de publication de la demande: **24.06.2015**
(21) Numéro de dépôt: 13198806.5
(22) Date de dépôt: 20.12.2013
(51) Int. Cl.: G04B 1/16

(54) **Barillet d'horlogerie optimisé**

(71) Demandeur: ETA SA Manufacture Horlogère Suisse, 2540 Grenchen (CH)
(72) Inventeur: Kaeser, Sébastien, 2022 Bevaix (CH); Nicoud, Serge, 2525 Le Landeron (CH); Röthlisberger, Marc, 3007 Bern (CH)
(74) Mandataire: Giraud, Eric

(57) **Abrégé**

Barillet (1) d'horlogerie comportant un tambour (2) avec une première surface d'appui de ressort (20) d'une chambre (4) de réception d'un ressort (3), comportant un alésage (11) pour le guidage en pivotement d'une bonde (9) et bordé par une surface d'appui de butée intérieure (12) adjacente à ladite paroi interne latérale (5), et par une surface d'appui de butée extérieure (13).

Ladite première surface d'appui de ressort (20) du côté de ladite chambre (4) comporte un revêtement anti-usure ou un DLC, et ledit alésage (11) est exempt de tout revêtement anti-usure et de tout revêtement DLC.

Procédé de réalisation d'un tel barillet:
- on réalise un tel tambour (2) ;
- on épargne au moins ledit alésage (11) pour empêcher l'action d'un traitement anti-usure ou DLC ;
- on effectue, sur la totalité dudit tambour (2) à l'exception de la zone ainsi épargnée, un traitement anti-usure ou DLC.

## Description

### Domaine de l'invention

L'invention concerne un barillet d'horlogerie comportant au moins un tambour pour la réception d'au moins un ressort de barillet enroulé en spirale dans une chambre délimitée partiellement par une première surface d'appui de ressort, et ledit tambour comportant au moins un premier alésage pour le guidage en pivotement d'une bonde ou d'un arbre, lequel premier alésage est bordé de part et d'autre, d'une part par une première surface d'appui de butée intérieure adjacente à ladite première surface d'appui de ressort et d'autre part par une première surface d'appui de butée extérieure.

L'invention concerne un mouvement d'horlogerie comportant au moins un tel barillet.

L'invention concerne un pièce d'horlogerie comportant au moins un tel mouvement ou/et au moins un tel barillet.

L'invention concerne un procédé de réalisation d'un barillet d'horlogerie pour sa protection contre l'usure sous l'action du frottement d'un ressort.

L'invention concerne le domaine des mécanismes d'horlogerie comportant des ressorts en contact de frottement, et plus particulièrement les barillets moteurs et les barillets de sonnerie.

### Arrière-plan de l'invention

Le barillet est la réserve d'énergie d'une montre mécanique. Il est comporte notamment tambour, coopérant avec un rouage, et qui est agencé pour recevoir, dans une chambre intérieure, au moins un ressort spiral lequel est accroché à son extrémité intérieur à un arbre ou à une bonde. La chambre de réception du ressort, ou des ressorts s'il y en a plusieurs, est généralement obturée par un couvercle, ou bien directement par le rochet venant usuellement sur l'arbre ou sur la bonde.

Ce tambour, et, selon le cas, ce couvercle ou ce rochet, peuvent être recouverts d'un traitement DLC ou d'un autre traitement anti-usure, notamment par revêtement PVD ou CVD, afin d'en améliorer la durée de vie, ceci en réduisant l'usure sur leurs surfaces internes provoquée par le frottement du ressort de barillet. La fiabilité du produit est alors également améliorée.

L'observation de la tenue dans le temps de barillets ainsi protégés montre que, du fait des propriétés intrinsèques de tels traitements, qu'ils soient superficiels ou à coeur ou encore par revêtement, projection, ou autre (et qu'on nommera ci-après indifféremment « traitements »), une usure prématurée peut se créer au niveau du pivotement en raison des propriétés de surface et tribologiques des zones traitées anti-usure, qui peuvent altérer les axes de pivotement ou similaires.

### Résumé de l'invention

L'invention se propose de réaliser des barillets résistant bien à l'usure des ressorts de tout type, et résistant bien à l'usure au niveau des pivotements.

A cet effet, l'invention concerne un barillet d'horlogerie comportant au moins un tambour pour la réception d'au moins un ressort de barillet enroulé en spirale dans une chambre délimitée partiellement par une première surface d'appui de ressort, et ledit tambour comportant au moins un premier alésage pour le guidage en pivotement d'une bonde ou d'un arbre, lequel premier alésage est bordé de part et d'autre, d'une part par une première surface d'appui de butée intérieure adjacente à ladite première surface d'appui de ressort et d'autre part par une première surface d'appui de butée extérieure, caractérisé en ce que au moins ladite première surface d'appui de ressort du côté de ladite chambre comporte un revêtement anti-usure ou un revêtement DLC pour résister à l'usure lors du frottement dudit ressort, et en ce que ledit premier alésage ou/et ladite première surface d'appui de butée intérieure ou/et ladite première surface d'appui de butée extérieure est exempt ou exempte de tout revêtement anti-usure et de tout revêtement DLC.

L'invention concerne un mouvement d'horlogerie comportant au moins un tel barillet.

L'invention concerne un pièce d'horlogerie comportant au moins un tel mouvement ou/et au moins un tel barillet.

L'invention concerne un procédé de réalisation d'un barillet d'horlogerie pour sa protection contre l'usure sous l'action du frottement d'un ressort, caractérisé en ce que :
- on réalise un tambour comportant une première surface d'appui de ressort sur le côté d'une chambre de réception de ressort, ledit tambour comportant au moins un premier alésage bordé de part et d'autre, d'une part par une première surface d'appui de butée intérieure adjacente à ladite première paroi interne latérale, et d'autre part par une première surface d'appui de butée extérieure;
- on épargne au moins ledit premier alésage pour empêcher l'action d'un traitement anti-usure par revêtement PVD ou CVD ou d'un traitement DLC ;
- on effectue, sur la totalité dudit tambour à l'exception de la zone ainsi épargnée, un traitement anti-usure par revêtement PVD ou CVD ou un traitement DLC.

### Description sommaire des dessins

D'autres caractéristiques et avantages de l'invention apparaîtront à la lecture de la description détaillée qui va suivre, en référence aux dessins annexés, où :

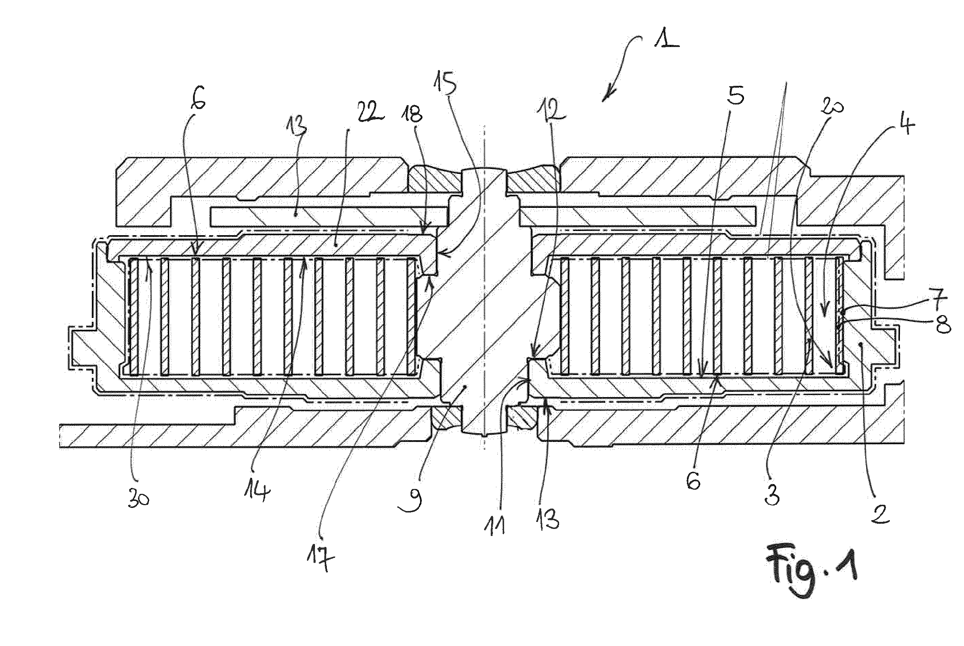

- la figure 1 représente, de façon schématisée et en coupe passant par son axe de pivotement, un barillet selon l'invention, comportant un tambour fermé par un couvercle ;

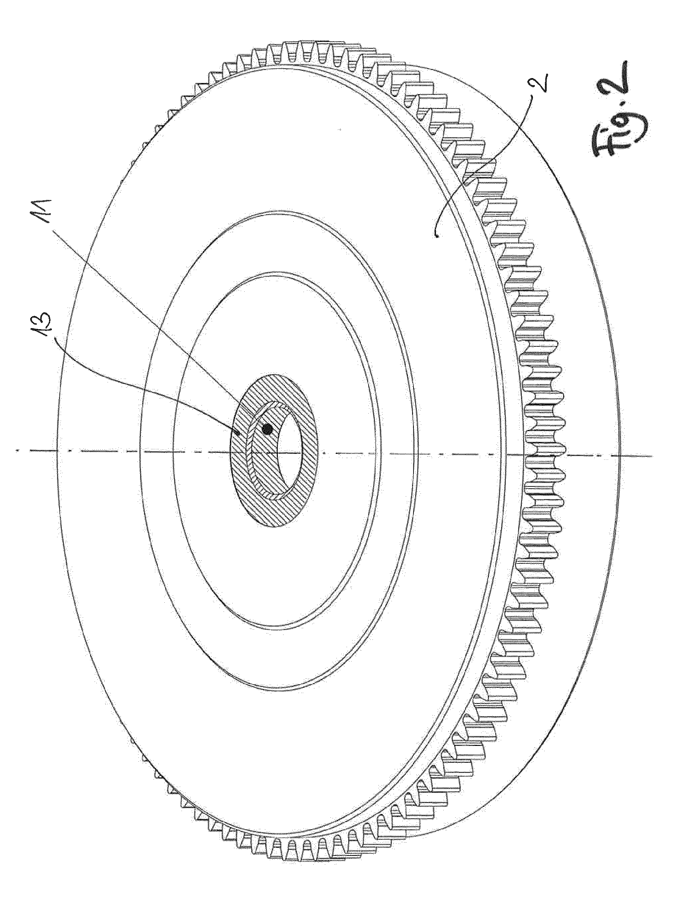

- la figure 2 représente, de façon schématisée et en perspective, le tambour du barillet de la figure 1, vu du côté extérieur opposé à la chambre de réception du ressort de barillet ;

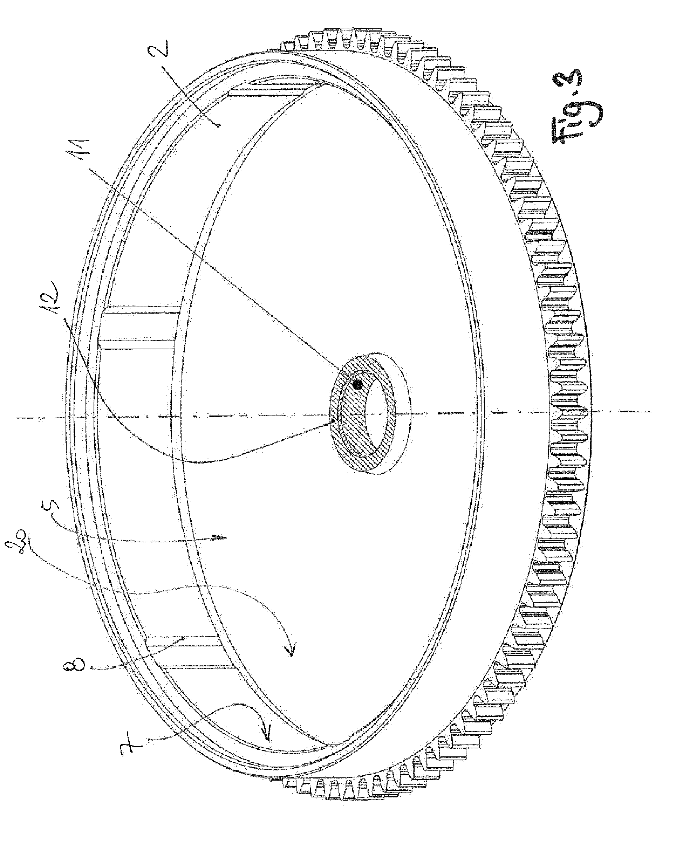

- la figure 3 représente, de façon schématisée et en perspective, le tambour du barillet de la figure 1, vu du côté intérieur de la chambre de réception du ressort de barillet ;

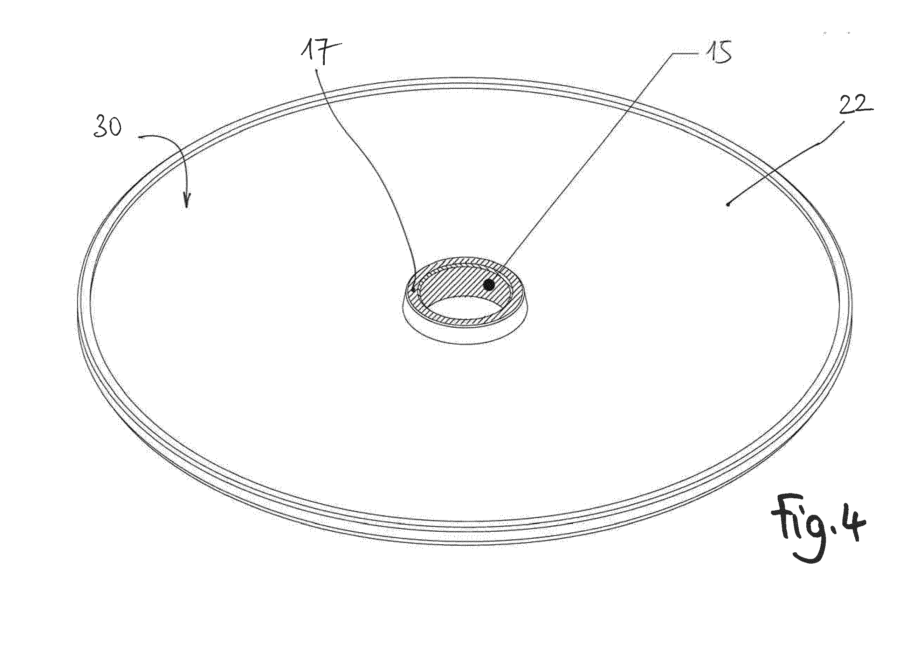

- la figure 4 représente, de façon schématisée et en perspective, le couvercle du barillet de la figure 1, vu du côté intérieur de la chambre de réception du ressort de barillet ;

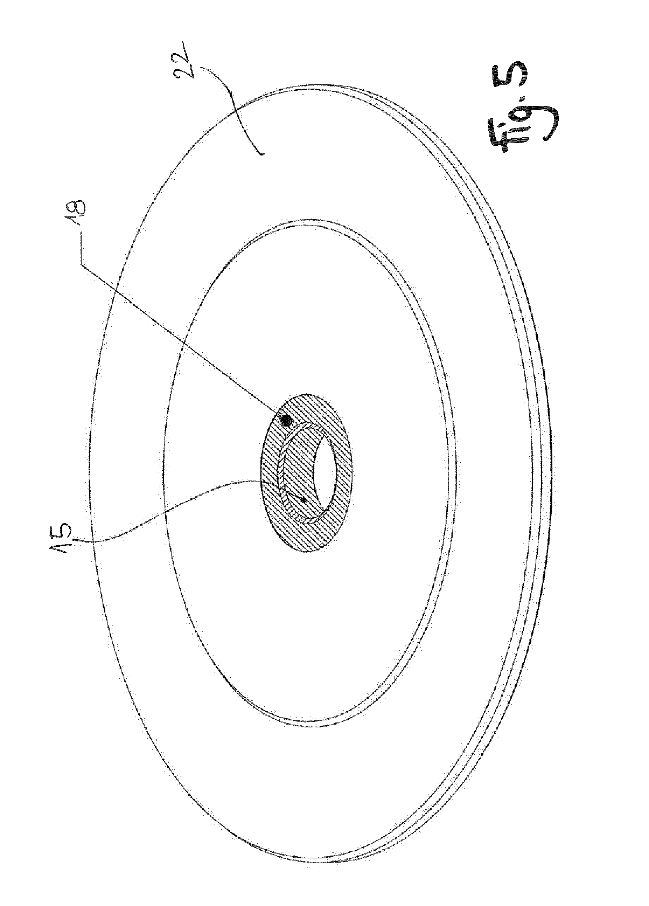

- la figure 5 représente, de façon schématisée et en perspective, le couvercle du barillet de la figure 1, vu du côté extérieur opposé à la chambre de réception du ressort de barillet ;
- la figure 6 représente, de façon schématisée et en coupe passant par son axe de pivotement, le tambour du barillet de la figure 1 équipé d'un outillage de cachage et monté sur un outillage de maintien pour son traitement anti-usure ;
- la figure 7 représente, de façon schématisée et en coupe passant par son axe de pivotement, le couvercle du barillet de la figure 1 équipé d'un outillage de cachage et monté sur un outillage de maintien pour son traitement anti-usure ;
- les figures 8 à 10 illustrent, en section passant par leur axe de pivotement, différentes variantes, non limitatives, de barillet selon l'invention :

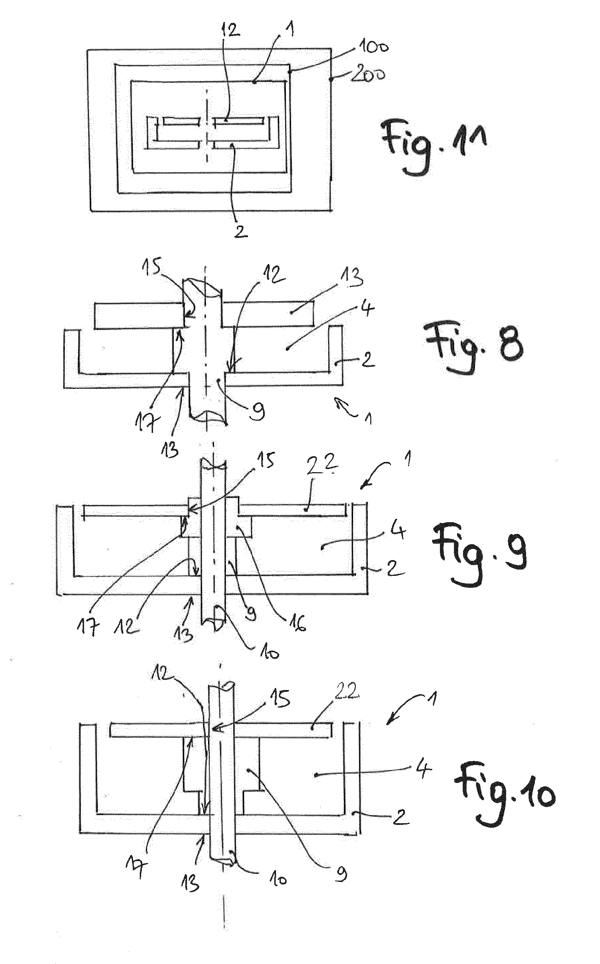

- la figure 8 avec un arbre faisant bonde sur lequel pivote le tambour et qui porte un rochet fermant la chambre du ressort ;
- la figure 9 avec un arbre lisse sur lequel pivote le tambour et qui porte une bonde et une douille d'entraînement d'un couvercle de fermeture de la chambre du ressort ;
- la figure 10 avec un arbre lisse traversant sur lequel pivote le tambour, et qui porte une bonde, et entraîne un couvercle de fermeture de la chambre du ressort ;
- la figure 11 représente, sous forme d'un schéma-blocs, une pièce d'horlogerie comportant un mouvement comportant lui-même un barillet selon l'invention.

### Description détaillée des modes de réalisation préférés

L'invention concerne le domaine des mécanismes d'horlogerie comportant des ressorts en contact de frottement, et plus particulièrement les barillets moteurs et les barillets de sonnerie.

Afin d'éviter les problèmes d'usure au niveau des pivotements, il faut éviter de faire, au niveau des surfaces de pivotement (alésages d'arbres, faces d'appui), des traitements anti-usure conférant au matériau une dureté élevée, que ces traitements soient de type traitement thermique ou par induction, traitement de surface, revêtement, projection, ou autre, appelés indifféremment ci-après « traitement ». Plus particulièrement, quand, de façon avantageuse, on protège les surfaces susceptibles d'être en contact de frottement avec un ressort, par traitement DLC ou similaire, on évite, selon l'invention, de déposer dans le pivotement le DLC, ou tout autre revêtement PVD/ CVD (et procédés apparentés), ceci même en quantité limitée, en assurant une étanchéité vis-à-vis du gaz porteur durant le processus de déposition de la couche et sous-couches d'accroche.

L'invention concerne ainsi un barillet 1 d'horlogerie comportant au moins un tambour 2 pour la réception d'au moins un ressort 3 de barillet enroulé en spirale dans une chambre 4 délimitée partiellement par une première surface d'appui de ressort 20. Cette première surface d'appui de ressort 20 comporte, ou bien une première paroi interne latérale 5 du tambour 2 faisant face à une tranche 6 d'au moins un tel ressort 3, ou bien une surface interne périphérique 7 (au niveau de laquelle le tambour 2 comportant généralement des moyens d'accrochage périphériques 8 d'un ressort 3), ou bien et de préférence à la fois cette première paroi interne latérale 5 et cette surface interne périphérique 7. L'invention est décrite plus particulièrement dans cette dernière alternative, l'homme du métier saura l'extrapoler à une seule des surfaces 5 ou 7.

Le tambour 2 comporte au moins un premier alésage 11 pour le guidage en pivotement d'une bonde 9 ou d'un arbre 10. Ce premier alésage 11 est bordé de part et d'autre, d'une part par une première surface d'appui de butée intérieure 12 adjacente à la première paroi interne latérale 5, et d'autre part par une première surface d'appui de butée extérieure 13.

Selon l'invention, au moins la première surface d'appui de ressort 20 comporte un revêtement anti-usure ou un revêtement DLC pour résister à l'usure lors du frottement du ressort 3, et le premier alésage 11 ou/et la première surface d'appui de butée intérieure 12 ou/et la première surface d'appui de butée extérieure 13 est exempt ou exempte de tout revêtement anti-usure et de tout revêtement DLC.

Dans une réalisation particulière, le premier alésage 11 est exempt de tout revêtement anti-usure et de tout revêtement DLC.

Dans une réalisation particulière, la première surface d'appui de butée intérieure 12 est exempte de tout revêtement anti-usure et de tout revêtement DLC.

Dans une réalisation particulière, la première surface d'appui de butée extérieure 13 est exempte de tout revêtement anti-usure et de tout revêtement DLC.

Dans une réalisation particulière avantageuse, la totalité des surfaces du tambour 2 comporte un revêtement anti-usure ou un revêtement DLC, à l'exception du premier alésage 11, qui est exempt de tout revêtement anti-usure et de tout revêtement DLC.

Dans une réalisation particulière, la totalité des surfaces du tambour 2 comporte un revêtement anti-usure ou un revêtement DLC, à l'exception du premier alésage 11 et de la première surface d'appui de butée intérieure 12, qui sont exempts de tout revêtement anti-usure et de tout revêtement DLC.

Dans une réalisation particulièrement avantageuse, la totalité des surfaces du tambour 2 comporte un revêtement anti-usure ou un revêtement DLC, à l'exception du premier alésage 11 et de la première surface d'appui de butée intérieure 12 et de la première surface d'appui de butée extérieure 13, qui sont exempts de tout revêtement anti-usure et de tout revêtement DLC.

Le mode de protection appliquée au tambour 2 est applicable au couvercle 22 ou au rochet 13, selon le cas, qui referme la chambre 4 de réception du (ou des) ressort 3.

Ainsi, avantageusement, le barillet 1 comporte, pour la fermeture de la chambre 4, du côté opposé à la première paroi interne latérale 5, un couvercle 22 ou un rochet 13 comportant une deuxième surface d'appui de ressort 30. Cette deuxième surface d'appui de ressort 30 comporte notamment une deuxième paroi interne latérale 14, opposée à la première paroi interne latérale 5. Ce couvercle 22 ou rochet 13 comporte un deuxième alésage 15 pour le guidage en pivotement d'une telle bonde 9 ou d'un tel arbre 10, ou encore d'une douille 16, selon la configuration du barillet 1.

Et au moins la deuxième surface d'appui de ressort 30, notamment la surface de la deuxième paroi interne latérale 14 du côté de la chambre 4, comporte un revêtement anti-usure ou un revêtement DLC pour résister à l'usure lors du frottement d' un ressort 3.

Dans une réalisation particulière, ce deuxième alésage 15 est exempt de tout revêtement anti-usure et de tout revêtement DLC.

Ce couvercle 22 ou rochet 13 refermant la chambre 4 comporte de préférence, connexe d'une part à la deuxième surface d'appui de ressort 30, notamment à la deuxième paroi interne latérale 14, et d'autre part au deuxième alésage 15, une deuxième surface d'appui de butée intérieure 17.

De façon similaire, le couvercle 22 ou le rochet 13 refermant la chambre 4 comporte, connexe au deuxième alésage 15 et à l'opposé de la chambre 4, une deuxième surface d'appui de butée extérieure 18.

Selon l'invention, ce deuxième alésage 15 ou/et cette deuxième surface d'appui de butée intérieure 17 ou/et cette deuxième surface d'appui de butée extérieure 18 est exempt ou exempte de tout revêtement anti-usure et de tout revêtement DLC.

Dans une réalisation particulière, ce deuxième alésage 15 est exempt de tout revêtement anti-usure et de tout revêtement DLC.

Dans une réalisation particulière, la deuxième surface d'appui de butée intérieure 17 qui est de préférence exempte de tout revêtement anti-usure et de tout revêtement DLC.

Dans une réalisation particulière, la deuxième surface d'appui de butée extérieure 18 qui est avantageusement exempte de tout revêtement anti-usure et de tout revêtement DLC.

Dans une réalisation particulière, la totalité des surfaces du couvercle 22 ou du rochet 13 refermant la chambre 4 comporte un revêtement anti-usure ou un revêtement DLC, à l'exception du deuxième alésage 15, qui est exempt de tout revêtement anti-usure et de tout revêtement DLC.

Dans une réalisation particulière, la totalité des surfaces du couvercle 22 ou du rochet 13 refermant la chambre 4 comporte un revêtement anti-usure ou un revêtement DLC, à l'exception du premier alésage 11 et de la première surface d'appui de butée intérieure 12, qui sont exempts de tout revêtement anti-usure et de tout revêtement DLC.

Dans une réalisation particulière, la totalité des surfaces du couvercle 22 ou du rochet 13 refermant la chambre 4 comporte un revêtement anti-usure ou un revêtement DLC, à l'exception du premier alésage 11 et de la première surface d'appui de butée intérieure 12 et de la première surface d'appui de butée extérieure 13, qui sont exempts de tout revêtement anti-usure et de tout revêtement DLC.

L'invention concerne encore un mouvement d'horlogerie 100 comportant au moins un tel barillet 1.

L'invention concerne encore une pièce d'horlogerie 200 comportant au moins un tel mouvement 100 ou/et au moins un tel barillet 1.

L'invention concerne encore un procédé de réalisation d'un barillet d'horlogerie 1 pour sa protection contre l'usure sous l'action du frottement d'un ressort. Selon ce procédé :
- on réalise un tambour 2 comportant une première surface d'appui de ressort 20, le tambour 2 comportant au moins un premier alésage 11 bordé de part et d'autre, d'une part par une première surface d'appui de butée intérieure 12 adjacente à la première surface d'appui de ressort 20, et d'autre part par une première surface d'appui de butée extérieure 13 ;
- on épargne au moins le premier alésage 11 pour empêcher l'action d'un traitement anti-usure par revêtement PVD ou CVD ou d'un traitement DLC ;
- on effectue, sur la totalité du tambour 2 à l'exception de la zone ainsi épargnée, un traitement anti-usure par revêtement PVD ou CVD ou un traitement DLC.

Dans une mise en oeuvre particulière de ce procédé, lors de cette épargne, on épargne aussi la première surface d'appui de butée intérieure 12.

Dans une mise en oeuvre particulière de ce procédé, lors de cette épargne, on épargne aussi la première surface d'appui de butée extérieure 13.

Dans une mise en oeuvre particulière de ce procédé, on réalise encore, pour la fermeture d'une chambre 4 de réception d'au moins un ressort, un couvercle 22 ou un rochet 13 comportant une deuxième surface d'appui de ressort 30 et un deuxième alésage 15 bordé de part et d'autre, d'une part par une deuxième surface d'appui de butée intérieure 17, et d'autre part par une deuxième surface d'appui de butée extérieure 18, et:
- on épargne au moins le deuxième alésage 15 pour empêcher l'action d'un traitement anti-usure par revêtement PVD ou CVD ou d'un traitement DLC ;
- on effectue, sur la totalité du couvercle 22 ou rochet 13 à l'exception de la zone ainsi épargnée, un traitement anti-usure par revêtement PVD ou CVD ou un traitement DLC.

Dans une mise en oeuvre particulière de ce procédé, lors de cette épargne, on épargne aussi la deuxième surface d'appui de butée intérieure 17.

Dans une mise en oeuvre particulière de ce procédé, lors de cette épargne, on épargne aussi la deuxième surface d'appui de butée extérieure 18.

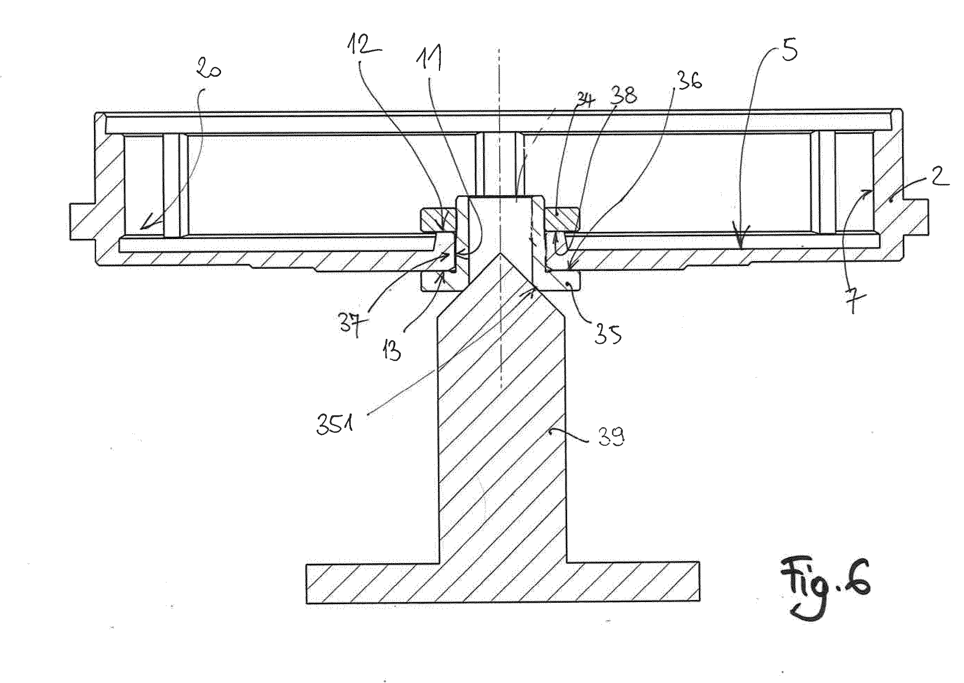

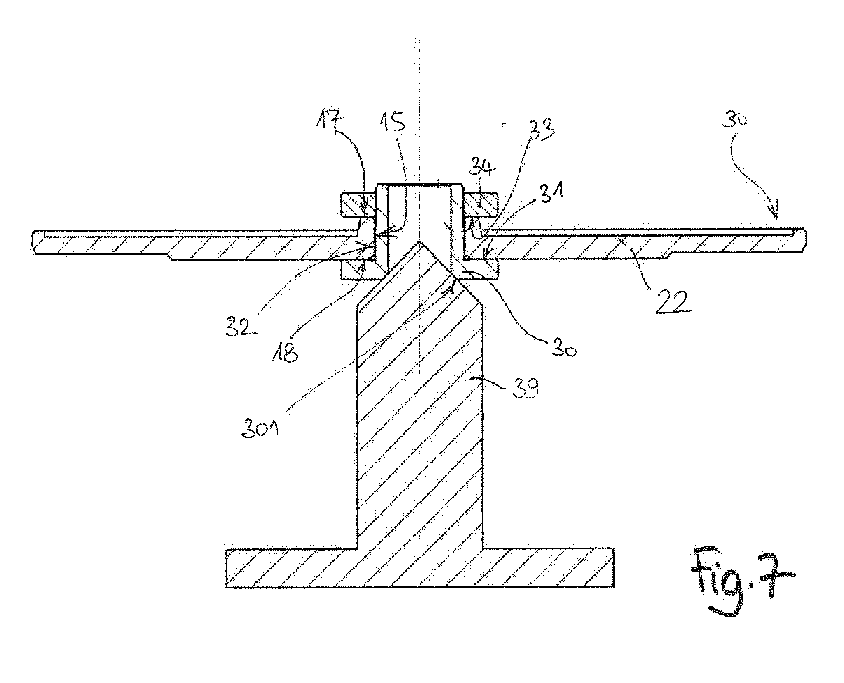

Les figures 6 et 7 illustrent des outillages de réalisation du traitement anti-usure, notamment DLC, avec des moyens d'épargne des alésages et des surfaces d'appui connexes :
- pour le tambour 2, en figure 6, une bague épaulée 35, conductrice, notamment en laiton, est montée glissante avec une portée 37 dans l'alésage 11 du tambour 2, en appui par une surface frontale 36 sur la première surface d'appui de butée extérieure 13 . Une bague conductrice 34 est chassée sur cette bague épaulée 35 et vient en appui, par une surface frontale 38, sur la première surface d'appui de butée intérieure 12. La bague épaulée 35 est portée par un support conducteur 39 comportant une portée conique sur laquelle repose un chanfrein 351 de la bague épaulée 35. De préférence, le tambour 2 est en laiton ou similaire ;
- de façon similaire, pour le couvercle 22, en figure 7, une bague épaulée 30, conductrice, notamment en laiton, est montée glissante avec une portée 32 dans l'alésage 15 du couvercle 22, en appui par une surface frontale 31 sur la deuxième surface d'appui de butée extérieure 18 . Une bague conductrice 34 est chassée sur cette bague épaulée 30 et vient en appui, par une surface frontale 33, sur la deuxième surface d'appui de butée intérieure 17. La bague épaulée 30 est portée par un support conducteur 39 comportant une portée conique sur laquelle repose un chanfrein 301 de la bague épaulée 30. De préférence, le couvercle 2 est en laiton ou similaire.

## Revendications

1. Barillet (1) d'horlogerie comportant au moins un tambour (2) pour la réception d'au moins un ressort (3) de barillet enroulé en spirale dans une chambre (4) délimitée partiellement par une première surface d'appui de ressort (20), et ledit tambour (2) comportant au moins un premier alésage (11) pour le guidage en pivotement d'une bonde (9) ou d'un arbre (10), lequel premier alésage (11) est bordé de part et d'autre, d'une part par une première surface d'appui de butée intérieure (12) adjacente à ladite première surface d'appui de ressort (20) et d'autre part par une première surface d'appui de butée extérieure (13), **caractérisé en ce que** au moins ladite première surface d'appui de ressort (20) du côté de ladite chambre (4) comporte un revêtement anti-usure ou un revêtement DLC pour résister à l'usure lors du frottement dudit ressort (3), et **en ce que** ledit premier alésage (11) ou/et ladite première surface d'appui de butée intérieure (12) ou/et ladite première surface d'appui de butée extérieure (13) est exempt ou exempte de tout revêtement anti-usure et de tout revêtement DLC.

2. Barillet (1) selon la revendication 1, **caractérisé en ce que** ledit premier alésage (11) est exempt de tout revêtement anti-usure et de tout revêtement DLC.

3. Barillet (1) selon la revendication 1 ou 2, **caractérisé en ce que** ladite première surface d'appui de butée intérieure (12) est exempte de tout revêtement anti-usure et de tout revêtement DLC.

4. Barillet (1) selon l'une des revendications 1 à 3, **caractérisé en ce que** ladite première surface d'appui de butée extérieure (13) est exempte de tout revêtement anti-usure et de tout revêtement DLC.

5. Barillet (1) selon la revendication 2, **caractérisé en ce que** la totalité des surfaces dudit tambour (2) comporte un revêtement anti-usure ou un revêtement DLC, à l'exception dudit premier alésage (11) qui est exempt de tout revêtement anti-usure et de tout revêtement DLC.

6. Barillet (1) selon la revendication 3, **caractérisé en ce que** la totalité des surfaces dudit tambour (2) comporte un revêtement anti-usure ou un revêtement DLC, à l'exception dudit premier alésage (11) et de ladite première surface d'appui de butée intérieure (12) qui sont exempts de tout revêtement anti-usure et de tout revêtement DLC.

7. Barillet (1) selon la revendication 4, **caractérisé en ce que** la totalité des surfaces dudit tambour (2) comporte un revêtement anti-usure ou un revêtement DLC, à l'exception dudit premier alésage (11) et de ladite première surface d'appui de butée intérieure (12) et de ladite première surface d'appui de butée extérieure (13) qui sont exempts de tout revêtement anti-usure et de tout revêtement DLC.

8. Barillet (1) selon l'une des revendications 1 à 7, **caractérisé en ce qu'**il comporte, pour la fermeture de ladite chambre (4), du côté opposé à ladite première paroi interne latérale (5), un couvercle (22) ou un rochet (13) comportant une deuxième surface d'appui de ressort (30) et comportant un deuxième alésage (15) pour le guidage en pivotement d'une dite bonde (9) ou d'un dit arbre (10) ou d'une douille (16), et **en ce que** au moins la surface de ladite deuxième surface d'appui de ressort (30) du côté de ladite chambre (4) comporte un revêtement anti-usure ou un revêtement DLC pour résister à l'usure lors du frottement dudit au moins un ressort (3), et **en ce que** ledit deuxième alésage (15) est exempt de tout revêtement anti-usure et de tout revêtement DLC.

9. Barillet (1) selon la revendication précédente, **caractérisé en ce que** ledit couvercle (22) ou ledit rochet (13) refermant ladite chambre (4) comporte, connexe à ladite deuxième surface d'appui de ressort (30) et audit deuxième alésage (15), une deuxième surface d'appui de butée intérieure (17) qui est exempte de tout revêtement anti-usure et de tout revêtement DLC.

10. Barillet (1) selon la revendication 8 ou 9, **caractérisé en ce que** ledit couvercle (22) ou ledit rochet (13) refermant ladite chambre (4) comporte, connexe audit deuxième alésage (15) et à l'opposé de ladite chambre (4), une deuxième surface d'appui de butée extérieure (18) qui est exempte de tout revêtement anti-usure et de tout revêtement DLC.

11. Barillet (1) selon la revendication 8, **caractérisé en ce que** la totalité des surfaces dudit couvercle (22) ou dudit rochet (13) refermant ladite chambre (4) comporte un revêtement anti-usure ou un revêtement DLC, à l'exception dudit deuxième alésage (15) qui est exempt de tout revêtement anti-usure et de tout revêtement DLC.

12. Barillet (1) selon la revendication 9, **caractérisé en ce que** la totalité des surfaces dudit couvercle (22) ou dudit rochet (13) refermant ladite chambre (4) comporte un revêtement anti-usure ou un revêtement DLC, à l'exception dudit deuxième alésage (15) et de ladite deuxième surface d'appui de butée intérieure (17) qui sont exempts de tout revêtement anti-usure et de tout revêtement DLC.

13. Barillet (1) selon la revendication 10, **caractérisé en ce que** la totalité des surfaces dudit couvercle (22) ou dudit rochet (13) refermant ladite chambre (4) comporte un revêtement anti-usure ou un revêtement DLC, à l'exception dudit deuxième alésage (15) et de ladite deuxième surface d'appui de butée intérieure (17) et de ladite deuxième surface d'appui de butée extérieure (18) qui sont exempts de tout revêtement anti-usure et de tout revêtement DLC.

14. Mouvement d'horlogerie (100) comportant au moins un barillet (1) selon l'une des revendications précédentes.

15. Pièce d'horlogerie (200) comportant au moins un mouvement (100) selon la revendication précédente ou/et au moins un barillet (1) selon l'une des revendications 1 à 13.

16. Procédé de réalisation d'un barillet d'horlogerie (1) pour sa protection contre l'usure sous l'action du frottement d'un ressort, **caractérisé en ce que** :
- on réalise un tambour (2) comportant une première surface d'appui de ressort (20) sur le côté d'une chambre (4) de réception de ressort, ledit tambour (2) comportant au moins un premier alésage (11) bordé de part et d'autre, d'une part par une première surface d'appui de butée intérieure (12) adjacente à ladite première paroi interne latérale (5), et d'autre part par une première surface d'appui de butée extérieure (13) ;
- on épargne au moins ledit premier alésage (11) pour empêcher l'action d'un traitement anti-usure par revêtement PVD ou CVD ou d'un traitement DLC ;
- on effectue, sur la totalité dudit tambour (2) à l'exception de la zone ainsi épargnée, un traitement anti-usure par revêtement PVD ou CVD ou un traitement DLC.

17. Procédé selon la revendication précédente, **caractérisé en ce que**, lors de ladite épargne, on épargne aussi ladite première surface d'appui de butée intérieure (12).

18. Procédé selon la revendication précédente, **caractérisé en ce que**, lors de ladite épargne, on épargne aussi ladite première surface d'appui de butée extérieure (13).

19. Procédé selon l'une des revendications 16 à 18, **caractérisé en ce qu'**on réalise encore, pour la fermeture d'une chambre (4) de réception d'au moins un ressort, un couvercle (22) ou un rochet (13) comportant une deuxième surface d'appui de ressort (30) et un deuxième alésage (15) bordé de part et d'autre, d'une part par une deuxième surface d'appui de butée intérieure (17), et d'autre part par une deuxième surface d'appui de butée extérieure (18), et **en ce que** :
- on épargne au moins ledit deuxième alésage (15) pour empêcher l'action d'un traitement anti-usure par revêtement PVD ou CVD ou d'un traitement DLC ;
- on effectue, sur la totalité dudit couvercle (22) ou rochet (13) à l'exception de la zone ainsi épargnée, un traitement anti-usure par revêtement PVD ou CVD ou un traitement DLC.

20. Procédé selon la revendication précédente, **caractérisé en ce que**, lors de ladite épargne, on épargne aussi ladite deuxième surface d'appui de butée intérieure (17).

21. Procédé selon la revendication précédente, **caractérisé en ce que**, lors de ladite épargne, on épargne aussi ladite deuxième surface d'appui de butée extérieure (18).
